# EUROPÄISCHE PATENTSCHRIFT

(11) **EP 1 203 801 B1**
(45) Veröffentlichungstag und Bekanntmachung des Hinweises auf die Patenterteilung: **25.03.2009**
(21) Anmeldenummer: 01124745.9
(22) Anmeldetag: 17.10.2001
(51) Int. Cl.: C09K 3/14, C09G 1/02, H01L 21/306, H01L 21/321

(54) **Wässrige Dispersion, Verfahren zu deren Herstellung und Verwendung**
Aqueous dispersion, process for its production and use
Dispersion aqueuse, procédé de sa préparation et utilisation de cette dispersion

(30) Priorität: 02.11.2000 DE 10054345
(43) Veröffentlichungstag der Anmeldung: 08.05.2002
(73) Patentinhaber: Evonik Degussa GmbH, 45128 Essen (DE)
(72) Erfinder: Lortz, Wolfgang, Dr., 63607 Wächtersbach (DE); Perlet, Gabriele, 63538 Grosskrotzenburg (DE); Batz-Sohn, Christoph, Dr., 63454 Hanau-Mittelbuchen (DE); Will, Werner, 63571 Gelnhausen (DE)

(56) Entgegenhaltungen:
- EP-A- 0 850 876
- WO-A-00/17282
- WO-A-95/06690
- US-A- 5 891 205

## Beschreibung

Die Erfindung betrifft die Herstellung wäßriger Dispersionen, die pyrogen hergestelltes Siliziumdioxid enthalten, ein Verfahren zur Herstellung und die Verwendung der Dispersionen zum Polieren von Halbleitersubstraten.

Ceroxid-Dispersionen, erhalten durch Calcinierung einer Cerverbindung und anschließendes Vermahlen des Oxides, werden seit langem zum Polieren von Glas eingesetzt. Die Dispersionen weisen Partikelgrößen von mehr als 1000 nm und einen hohen Anteil an Verunreinigungen auf. Sie sind geeignet für ein grobes Polieren von Oberflächen, nicht jedoch für das Polieren von empfindlichen optischen Oberflächen, Halbleitersubstraten oder integrierten Schaltkreisen (Chemisch-Mechanisches Polieren, CMP).

Kleinere Ceroxidpartikel werden bei der sogenannten Hydrothermalsynthese erhalten. Dabei wird ein Cer(III)-Salz unter Einfluß von Temperatur und Druck oxidativ in Ceroxid überführt, das in Form feiner Partikel auskristallisiert. Die Partikelgrößen des nach diesem Prozeß erhaltenen Ceroxides liegen bei 80-100 nm (EP-A-947 469), 7-50 nm (US 5 389 352) beziehungsweise kleiner als 30 nm und größer als 60 nm (US 5 772 780). Nachteilig bei dieser Methode ist, daß man von sehr verdünnten Cer(III)-Lösungen ausgegangen werden muß.

In US 5 891 205 sind Gemische aus nach oben genanntem Verfahren hergestellten Ceroxid und Siliziumdioxid beschrieben. Dabei muß das Ceroxid in einem ersten Schritt mittels einer Mühle deagglomeriert werden. In einem zweiten Schritt wird die Ceroxid-Dispersion mit einer Siliziumdioxid-Dispersion auf Basis Kieselsol gemischt und kann zum Planarisieren von Siliziumscheiben verwendet werden.

Nachteilig ist hier der hohe Aufwand und die Kosten, die zur Herstellung dieser feinteiligen Dispersion nötig sind. Die Deagglomeration des Ceroxides mittels einer Mühle birgt die Gefahr der Einschleusung von Verunreinigungen in die Dispersion. Ferner ist bekannt, daß Siliziumdioxid-Dispersionen auf Basis Kieselsol einen höheren Anteil an Verunreinigungen aufweisen als solche auf Basis pyrogen hergestellten Siliziumdioxides.

US 5 382 272 beschreibt die Aktivierung von Siliziumdioxidteilchen durch Adsorption von wenigen Gewichtsprozenten, bevorzugt zwei Gewichtsprozent, einer Cer- oder Zirkonoxiddispersion. Das Besondere an diesem Verfahren ist, daß sich der aktivierende Effekt einfach durch Vermahlen einer Siliziumdioxid-Dispersion mit einer kommerziell erhältlichen Cer- beziehungsweise ZirkonoxidDispersion einstellen soll. Die so erhaltene gemischte Dispersion soll sich beim Polieren von Halbleitersubstraten mit einer hohen Abtragsrate wie eine reine Ceroxid-Dispersion verhalten, jedoch ohne Kratzer auf der zu polierenden Oberfläche zu hinterlassen. Im Vergleich zum restlichen Stand der Technik sind die Kosten minimal und die Ausführung einfach. Besonders nachteilig bei dieser Methode ist, wie auch ausführlich in WO 00/17 282 A1 beschrieben, die Herstellung einer Dispersion mit engem Partikelgrößenbereich und das Erzielen reproduzierbarer Polierergebnisse.

Wie der Stand der Technik zeigt, besteht reges Interesse die außergewöhnlich hohe Aktivität von Ceroxid gegenüber Siliziumdioxid und anderen dielektrischen Oxiden hauptsächlich im Bereich chemisch-mechanisches Polieren (CMP)zu nutzen.

Die technische Aufgabe der Erfindung ist es, eine wäßrige, Ceroxid enthaltende Dispersion bereitzustellen, die sich einfach herstellen läßt, die nur einen geringen Anteil an Verunreinigungen aufweist, und bei der sich die Partikelgröße reproduzierbar einstellen läßt.

Die technische Aufgabe wird dadurch gelöst, daß man eine wäßrige Dispersion einsetzt, die ceroxid-dotiertes, pyrogen hergestelltes Siliziumdioxid enthält, wobei das Ceroxid über ein Aerosol aus einer Cersalzlösung oder -suspension eingebracht wird, und die mittlere Teilchengröße in der Dispersion kleiner 100 nm ist.

Bei der Herstellung des ceroxid-dotierten Siliziumdioxides geht man von einer Cersalzlösung oder -suspension aus, die als Aerosol mit dem Gasgemisch der Flammenoxidation beziehungsweise Flammenhydrolyse, eine flüchtige Siliziumverbindung wie zum Beispiel Siliziumtetrachlorid, Wasserstoff und Sauerstoff, homogen gemischt wird. Man läßt das Aerosol-Gasgemisch in einer Flamme abreagieren. Das entstandene pyrogen hergestellte, mittels Aerosol dotierte Siliziumdioxid wird in bekannter Weise vom Gasstrom abgetrennt.

Wie in DE 196 50 500 A1 ausführlich beschrieben, führt dieser Herstellungsprozess zu ceroxid-dotierten Siliziumdioxidpartikeln. Die Ceroxidpartikel nach diesem Prozeß sind stets kleiner als die Siliziumdioxidpartikel. Dies ist eine wichtige Voraussetzung für die Verwendung von Dispersionen enthaltend die ceroxid-dotierten Siliziumdioxidteilchen für Polieranwendungen, da sonst Kratzer auf der zu polierenden Oberfläche entstehen können.

Die Dispersion weist eine gute Stabilität auf und ist in idealer Weise geeignet zum Polieren im CMP-Bereich. Gute Stabilität der dotierten Dispersion heißt, daß der Zeitpunkt, an dem die Dispersion in ihrer Viskosität zunimmt, geliert oder sedimentiert, später eintritt als bei einer Dispersionen, enthaltend ein Gemisch aus nicht dotiertem Siliziumdioxid und Ceroxid.

Durch das pyrogene Herstellverfahren, bei dem bekannterweise von hochreinen Ausgangsmaterialien ausgegangen wird, sind die für CMP-Anwendungen relevanten Verunreinigungen vernachlässigbar klein.

Bei kommerziell erhältlichen Ceroxid-Dispersionen ist das Ceroxid meist aus Erzen mit einem vergleichsweisen hohen Anteil an Verunreinigungen gewonnen.

Der Dotierungsgrad kann bei nach obigem Verfahren hergestelltem Siliziumdioxid in weiten Grenzen von 0,00001 bis 20 Gew.-% variiert werden. Bei Verwendung zur Herstellung einer wässerigen Dispersion gemäß der vorliegenden Erfindung liegt der Dotierungsgrad bevorzugt zwischen 10 ppm und 10 Gew.-%. Besonders bevorzugt ist der Bereich zwischen 300 ppm und 5 Gew.-%.

Die BET-Oberfläche des ceroxid-dotierten Siliziumdioxides liegt in einer bevorzugten Ausführungsform der Erfindung zwischen 5 und 600 m²/g. Besonders bevorzugt ist ein Bereich zwischen 50 und 400 m²/g. Innerhalb dieses Bereiches zeigt die Dispersion eine gute Stabilität.

Der Feststoffgehalt der ceroxid-dotierten Siliziumdioxid enthaltenden Dispersion richtet sich in erster Linie nach der beabsichtigten Verwendung. Um Transportkosten einzusparen wird man eine Dispersion mit möglichst hohem Feststoffgehalt anstreben, während bei bestimmten Anwendungen, wie zum Beispiel beim Polieren von Siliziumscheiben, Dispersionen mit niedrigen Feststoffgehalten eingesetzt werden. Bevorzugt gemäß der Erfindung ist ein Feststoffgehalt von 0,1 bis 70 Gew.-%., besonders bevorzugt der Bereich zwischen 1 und 30 Gew.-%. In diesem Bereich zeigt die ceroxid-dotierte Dispersion eine gute Stabilität.

Die Dispersion kann als solche zum Beispiel zum Polieren eingesetzt werden. Der pH-Wert dieser Dispersion liegt, abhängig vom Dotierungsgrad, zwischen 3,5 und 4. Er kann jedoch in einem weiten pH-Bereich von ca. 3-11 durch Zugaben von basisch oder sauer wirkenden Substanzen variiert werden.

Eine Erhöhung des pH-Wertes kann bevorzugt durch Addition von Alkalihydroxiden oder Aminen erfolgen. Besonders bevorzugt sind Ammoniumhydroxid und Kaliumhydroxid.

Durch Zugabe von Säuren kann der pH-Wert in den sauren Bereich bis pH 3 verschoben werden. Bevorzugt werden hierzu Carbonsäuren der allgemeinen Formel CₙH₂ₙ₊₁CO₂H, mit n=0-6 oder n=8,10,12,14,16, oder Dicarbonsäuren der allgemeinen Formel HO₂C(CH₂)ₙCO₂H, mit n=0-4, oder Hydroxycarbonsäuren der allgemeinen Formel R₁R₂C(OH)CO₂H, mit R₁=H, R₂=CH₃, CH₂CO₂H, CH(OH)CO₂H oder Glykolsäure, Brenztraubensäure, Salicylsäure oder Mischungen der aufgeführten Säuren verwendet. Besonders bevorzugt sind hierzu Essigsäure, Zitronensäure und Salizylsäure.

Ein weiterer Gegenstand der Erfindung ist ein Verfahren zur Herstellung der Dispersion enthaltend ceroxid-dotiertes Siliziumdioxid, welches dadurch gekennzeichnet ist, daß man das ceroxid-dotierte, pyrogen hergestellte Siliziumdioxid in wäßriger Lösung mittels hohem Energieeintrag dispergiert. Hierzu eignen sich Dispergiermethoden, bei denen ein ausreichend hoher Energieeintrag eine Dispergierung auch sehr harter und stark aggregierter Materialien ermöglicht. Hierzu zählen Systeme nach dem Rotor-Stator-Prinzip, zum Beispiel Ultra-Turrax-Maschinen, oder Rührwerkskugelmühlen. Beide Systeme zeigen jedoch einen relativ geringen Energieeintrag. Deutliche höhere Energieeinträge sind mit einem Planetenkneter/-mixer möglich. Die Wirksamkeit dieses Systems ist jedoch mit einer ausreichend hohen Viskosität der bearbeiteten Mischung verbunden, um die benötigten hohen Scherenergien zum Zerteilen der Teilchen einzubringen.

Beim Vermahlen und Dispergieren dotierter Oxidpartikel besteht die Gefahr, daß der Dotierungsstoff während des Vermahlens und Dispergierens abgelöst wird. Dies führt, wenn die Dispersion beim CMP-Prozess als Poliermittel eingesetzt werden soll, zu uneinheitlichen Polierergebnissen.

Es wurde nun gefunden, daß mit Hochdruckhomogenisierern wäßrige Dispersionen erhalten werden können, die ceroxid-dotierte Siliziumdioxidteilchen enthalten, die kleiner als 100 nm sind und bei denen der Dotierstoff nicht abgelöst wird.

Bei diesen Vorrichtungen werden zwei unter einem Druck von bis zu 3500 kg/cm² stehende vordispergierte Suspensionsströme über eine Diamant-Düse entspannt. Beide Dispersionsstrahlen treffen exakt aufeinander und die Teilchen mahlen sich selbst. Bei einer anderen Ausführungsform wird die Vordispersion ebenfalls unter hohen Druck gesetzt, jedoch erfolgt die Kollision der Teilchen gegen gepanzerte Wandbereiche.

Diese Vorrichtungen wurden bislang unter anderem zur Dispergierung von nicht dotierten Oxiden, wie Zinkoxid, Siliziumdioxid, Aluminiumoxid verwendet (UK-A-2 063 695, EP-A-876 841, EP-A-773 270, WO 00/172 282 A1). Die Vermahlung und Dispergierung von dotierten Oxiden mit diesen Vorrichtungen ist bislang nicht beschrieben.

Ein weiterer Gegenstand der Erfindung ist die Verwendung der wässerigen, ceroxid-dotierten Dispersion zum chemisch-mechanischen Polieren (CMP) von Halbleitersubstraten oder von auf ihnen aufgebrachten Schichten. Mit der ceroxid-dotierten Dispersion kann bei einer hohen Polierrate eine mikrokratzerfreie Oberfläche erzielt werden.

Besonders geeignet ist die erfindungsgemäße ceroxid-dotierte Dispersion beim abschließenden chemisch-mechanischen Polieren im Shallow- Trench Isolation Prozeß (STI-Prozess), bei dem nach dem Aufbringen einer Siliziumnitridschicht Isolationsstrukturen in die Siliziumschicht eines Wafers geätzt werden, diese Gräben anschließend mit Siliziumdioxid gefüllt werden, und überschüssiges Siliziumdioxid durch chemisch-mechanisches Polieren entfernt wird.

Ferner eignen sich diese Dispersionen zur Herstellung sehr feinteiliger Oberflächenbeschichtungen im Papierbereich oder zur Erzeugung spezieller Gläser.

### Beispiele

### Analysenverfahren

Die durchschnittliche Sekundärteilchengröße wurde mit dem Zetasizer 3000 Hsa der Firma Malvern bestimmt.

Die Oberfläche der eingesetzten Pulver wurde nach der Methode von S. Brunauer, P. H. Emmet und I. Teller, J. Am. Chemical Society, Band 60, Seite 309 (1938) ermittelt und wird allgemein als BET-Oberfläche bezeichnet.

Die Viskosität der erzeugten Dispersionen wurde mit einem Rotations-Rheometer der Firma Physica Model MCR 300 und dem Meßbecher CC 27 ermittelt. Der Viskositätswert wurde bei einer Schergeschwindigkeit von 100 1/sec. ermittelt. Diese Schergeschwindigkeit liegt in einem Bereich, in dem die Viskosität praktisch unabhängig von der Scherbeanspruchung ist.

Die Beurteilung einer Bodensatzbildung erfolgte durch visuelle Beurteilung in einer 1000 ml Weithals-Polyethylen-Flasche nach einer Standzeit von einer Woche. Durch vorsichtiges Kippen der Flasche kann leicht ein gegebenenfalls vorhandener Bodensatz erkannt werden.

Die Synthese der Ceroxid-dotierten Siliciumdioxidpartikel erfolgt gemäß DE 196 50 500.

### Herstellung der Dispersionen

Methode A: In einem 60 l Edelstahl-Ansatzbehälter werden 53 kg VE-Wasser und 80g 30%ige KOH-Lösung vorgelegt. Mit Hilfe eines Dispergier- und Saugmischers der Firma Ystrahl (bei 4500 UpM) werden 8 kg der Partikel gemäß der Beispiele 1 bis 8 Pulver eingesaugt und grob vordispergiert. Nach dem Pulvereintrag wird die Dispergierung mit einem Rotor/Stator Durchlaufhomogenisator Typ Z 66 der Firma Ystral mit vier Bearbeitungskränzen, einer Statorschlitzbreite von 1 mm und einer Drehzahl von 11 500 UpM vervollständigt. Während dieser 15 minütigen Dispergierung mit 11 500 UpM wird der pH-Wert durch Zugabe von weiterer KOH-Lösung auf einen pH-Wert von 9,5 eingestellt und gehalten. Hierbei wurden weitere 96 g KOH-Lösung verwendet und durch Zugabe von 2,8 kg Wasser eine Abrasivkörper-Konzentration von 12,5 Gew. % eingestellt.

Methode B: Ca. die Hälfte der Dispersion nach Methode A wird mit einer "Wet-Jet-Mill": Ultimaizer System der Firma Sugino Machine Ltd., Modell HJP-25050, bei einem Druck von 250 MPa und einem Diamatdüsendurchmesser von 0,3 mm und zwei Mahl-Durchgängen vermahlen.

Die analytischen Daten der Dispersionen sind in Tabelle 1 dargestellt.

### Polierprozeß

Ausrüstung: Presi Polisher Type 460 M, ausgerüstet mit einem 550 mm Poliertisch mit Poliertuch Rodel IC 1400 perforiert.

Wafer: 4'' Siliciumscheiben beschichtet mit 500 nm SiO₂ (thermisch erzeugt), 4'' Siliciumscheiben beschichtet mit 500 nm Si₃N₄ (LPCVD).

Polierparameter:
Polierdauer/Polierdruck: 15 s/0.2 bar, 60 s/0.8 bar,
15 s/ 0.2 bar Spülung
Rotationsgeschwindigkeit 60 rpm (beide)
Dosiergeschwindigkeit Dispersion: 100 ml/min
Temperatur: ca. 25°C

Konditionierung: vor jedem Polierversuch mit einer Diamant-Schleifkopfscheibe bei 1 bar, Dauer 10 s.

Post CMP Cleaning erfolgt durch Ultraschallreinigung (Firma Techsonic) und einem Bürstenreiniger SVG 8620 single side cleaner/dryer.

Die Auswertung der Abtragsleistung (Removal Rate, RR) erfolgt durch Messungen der Schichtdicke mit dem Gerät Prometrix FDT 650 (KLA-Tencor Corporation) und durch Auswiegen der Wafer mit einer Satorius BP 210D Waage. Für die mittlere RR wurden jeweils 10 Wafer poliert und ausgewertet.

Grobe Kratzer und Defekte wurden mit einem Gerät der Firma Tencor Modell Surfscan 5000 ausgewertet.

Die Werte für die Abtragsleistungen und die Selektivitäten der Dispersionen nach den Beispielen 1 bis 8 sind in Tabelle 2 zusammengefasst.

**Tabelle 1: Analytische Daten der nach den Beispielen 1 bis 8 erhaltenen Dispersionen**

| Beispiel | Methode | CeO₂-Dotierung | BET-Oberfläche | Mittlerer Teilchen-durchmesser (Anzahl) | Mittlerer Teilchen-durchmesser (Volumen) | Viskosität | Bodensatz |
|---|---|---|---|---|---|---|---|
| | | [Gew.%] | [m²/g] | [nm] | [nm] | [mPas] | |
| 1 | A | keine* | 90 | 197 | 271 | 7 | ja |
| 2 | B | keine* | 90 | 150 | 163 | 3 | nein |
| 3 | A | 0,11 | 83 | 185 | 251 | 3 | ja |
| 4 | B | 0,11 | 83 | 84 | 96 | 2 | nein |
| 5 | A | 0,34 | 79 | 190 | 257 | 3 | ja |
| 6 | B | 0,34 | 79 | 78 | 92 | 2 | nein |
| 7 | A | 0,71 | 81 | 181 | 261 | 3 | ja |
| 8 | B | 0,71 | 81 | 91 | 99 | 2 | nein |

| | | | | | | | |
|---|---|---|---|---|---|---|---|
| * Aerosil 90, Degussa AG. | | | | | | | |

**Tabelle 2: Mittlere Abtragsleistung (RR) und Selektivitäten SiO₂/Si₃N₄ der nach den Beispielen 1 bis 8 hergestellten Dispersionen**

| Beispiel | thermisches SiO₂ | | Si₃N₄ | | Selektivität RR SiO₂/RR Si₃N₄ | | Kratzer/Defekte |
|---|---|---|---|---|---|---|---|
| | Wiegung [nm/min] | Prometrix [nm/min] | Wiegung [nm/min] | Prometrix [nm/min] | Wiegung | Prometrix | |
| 1 | 1078 | 1005 | 325 | 303 | 3,3 | 3,4 | einige |
| 2 | 1023 | 956 | 321 | 313 | 3,3 | 3,3 | keine |
| 3 | 1153 | 1072 | 331 | 315 | 3,5 | 3,4 | wenige |
| 4 | 1197 | 1021 | 339 | 293 | 3,5 | 3,5 | keine |
| 5 | 1337 | 1275 | 311 | 298 | 4,3 | 4,3 | wenige |
| 6 | 1297 | 1226 | 299 | 292 | 4,3 | 4,2 | keine |
| 7 | 1627 | 1558 | 316 | 310 | 5,1 | 5,0 | wenige |
| 8 | 1580 | 1506 | 305 | 308 | 5,2 | 4,9 | keine |

## Patentansprüche

1. Wäßrige Dispersion, **dadurch gekennzeichnet, daß** diese ein ceroxid-dotiertes, pyrogen hergestelltes Siliziumdioxid enthält, wobei das Ceroxid über ein Aerosol aus einer Cersalzlösung oder -suspension eingebracht wird und die durchschnittliche Teilchengröße in der Dispersion kleiner als 100 nm ist.

2. Wäßrige Dispersion nach Anspruch 1, **dadurch gekennzeichnet, daß** der Cergehalt des dotierten Siliziumdioxides zwischen 10 ppm und 10 Gew.-% liegt.

3. Wäßrige Dispersion nach Anspruch 1-2, **dadurch gekennzeichnet, daß** die BET-Oberfläche des ceroxid-dotierten Siliziumdioxides zwischen 5 und 600 m²/g ist.

4. Wäßrige Dispersion nach Anspruch 1-3, **dadurch gekennzeichnet, daß** der Feststoffgehalt in der Dispersion zwischen 0,1 und 70 Gew.-% liegt.

5. Wäßrige Dispersion nach Anspruch 1-4, **dadurch gekennzeichnet, daß** der pH-Wert der Dispersion zwischen 3 und 11 liegt.

6. Wäßrige Dispersion nach Anspruch 1-5, **dadurch gekennzeichnet, daß** der pH-Wert mit Aminen oder Alkalihydroxiden eingestellt wird.

7. Wäßrige Dispersion nach Anspruch 1-5, **dadurch gekennzeichnet, daß** der pH-Wert mit Carbonsäuren der allgemeinen Formel CₙH₂ₙ₊₁CO₂H, mit n=0-6 oder n=8,10,12,14,16, oder Dicarbonsäuren der allgemeinen Formel HO₂C(CH₂)ₙCO₂H, mit n=0-4, oder Hydroxycarbonsäuren der allgemeinen Formel R₁R₂C(OH)CO₂H, mit R₁=H, R₂=CH₃, CH₂CO₂H, CH(OH)CO₂H oder Glykolsäure, Brenztraubensäure, Salizylsäure oder Mischungen daraus, eingestellt wird.

8. Verfahren zur Herstellung einer wäßrigen Dispersion nach Anspruch 1 bis 7, **dadurch gekennzeichnet, daß** man das ceroxid-dotierte, pyrogen hergestellte Siliziumdioxid in wäßriger Lösung mittels hohem Energieeintrag dispergiert.

9. Verfahren zur Herstellung einer wäßrigen Dispersion nach Anspruch 8, **dadurch gekennzeichnet, daß** zur Vermahlung und Dispergierung eines ceroxid-dotierten Siliziumdioxides in einem wässerigen Lösungsmittel eine Vorrichtung Verwendung findet, bei der die zu dispergierenden Teilchen unter einem Druck von bis zu 3500 kg/cm² stehen, über eine Düse entspannt werden und miteinander oder gegen Wandbereiche der Vorrichtung kollidieren.

10. Verwendung der wäßrigen Dispersion nach Anspruch 1-7 zum chemisch-mechanischen Polieren von Halbleitersubstraten oder von auf ihnen aufgebrachten Schichten.

11. Verwendung der wäßrigen Dispersion nach Anspruch 1-7 zur Erzeugung feinteiliger Oberflächenbeschichtungen im Papierbereich.

12. Verwendung der wäßrigen Dispersion nach Anspruch 1-7 zur Erzeugung spezieller Gläser.

## Claims

1. Aqueous dispersion, **characterized in that** it comprises a cerium oxide-doped, pyrogenically produced silicon dioxide, the cerium oxide being introduced via an aerosol of a cerium salt solution or suspension and the average particle size in the dispersion being less than 100 nm.

2. Aqueous dispersion according to Claim 1, **characterized in that** the cerium content of the doped silicon dioxide is between 10 ppm and 10 wt. %.

3. Aqueous dispersion according to Claim 1-2, **characterized in that** the BET surface area of the cerium oxide-doped silicon dioxide is between 5 and 600 m²/g.

4. Aqueous dispersion according to Claim 1-3, **characterized in that** the solids content in the dispersion is between 0.1 and 70 wt. %.

5. Aqueous dispersion according to Claim 1-4, **characterized in that** the pH of the dispersion is between 3 and 11.

6. Aqueous dispersion according to Claim 1-5, **characterized in that** the pH is set with amines or alkali metal hydroxides.

7. Aqueous dispersion according to Claim 1-5, **characterized in that** the pH is set with carboxylic acids of the general formula CₙH₂ₙ₊₁CO₂H, where n = 0-6 or n = 8, 10, 12, 14, 16, or dicarboxylic acids of the general formula HO₂C(CH₂)ₙCO₂H, where n = 0-4, or hydroxycarboxylic acids of the general formula R₁R₂C(OH)CO₂H, where R₁ = H, R₂ = CH₃, CH₂CO₂H, CH(OH)CO₂H or glycolic acid, pyruvic acid, salicylic acid or mixtures thereof.

8. Process for the production of an aqueous dispersion according to Claim 1 to 7, **characterized in that** the cerium oxide-doped, pyrogenically produced silicon dioxide is dispersed in aqueous solution by means of a high energy input.

9. Process for the production of an aqueous dispersion according to Claim 8, **characterized in that** an apparatus is used for grinding and dispersing a cerium oxide-doped silicon dioxide in an aqueous solvent where the particles to be dispersed are under a pressure of up to 3500 kg/cm², are depressurized via a nozzle and collide with one another or against wall regions of the apparatus.

10. Use of the aqueous dispersion according to Claim 1-7 for chemical-mechanical polishing of semiconductor substrates or of layers applied thereto.

11. Use of the aqueous dispersion according to Claim 1-7 for producing finely particulate surface coatings in the paper sector.

12. Use of the aqueous dispersion according to Claim 1-7 for producing special glasses.

## Revendications

1. Dispersion aqueuse, **caractérisée en ce qu'**elle contient un dioxyde de silicium préparé par pyrogénation, dopé à l'oxyde de cérium, l'oxyde de cérium étant introduit au moyen d'un aérosol à base d'une suspension ou solution de sel de cérium, et la taille moyenne de particule dans la dispersion étant inférieure à 100 nm.

2. Dispersion aqueuse selon la revendication 1, **caractérisée en ce que** la teneur en cérium du dioxyde de silicium dopé est comprise entre 10 ppm et 10 % en poids.

3. Dispersion aqueuse selon la revendication 1 ou 2, **caractérisée en ce que** la surface BET du dioxyde de silicium dopé à l'oxyde de cérium est comprise entre 5 et 600 m²/g.

4. Dispersion aqueuse selon l'une quelconque des revendications 1 à 3, **caractérisée en ce que** la teneur en matière solide de la dispersion est comprise entre 0,1 et 70 % en poids.

5. Dispersion aqueuse selon l'une quelconque des revendications 1 à 4, **caractérisée en ce que** le pH de la dispersion est compris entre 3 et 11.

6. Dispersion aqueuse selon l'une quelconque des revendications 1 à 5, **caractérisée en ce que** le pH est ajusté à l'aide d'amines ou d'hydroxydes de métaux alcalins.

7. Dispersion aqueuse selon l'une quelconque des revendications 1 à 5, **caractérisée en ce que** le pH est ajusté à l'aide d'acides carboxyliques de formule générale CₙH₂ₙ₊₁CO₂H, où n = 0-6 ou n = 8, 10, 12, 14, 16, ou d'acides dicarboxyliques de formule générale HO₂C(CH₂)ₙCO₂H, où n = 0-4, ou d'acides hydroxycarboxyliques de formule générale R₁R₂C(OH)CO₂H, où R₁ = H, R₂ =CH₃, CH₂CO₂H, CH(OH)CO₂H ou d'acide glycolique, d'acide pyruvique, d'acide salicylique ou de mélanges de ceux-ci.

8. Procédé pour la préparation d'une dispersion aqueuse selon l'une quelconque des revendications 1 à 7, **caractérisé en ce qu'**on disperse dans une solution aqueuse, au moyen d'un fort apport d'énergie, le dioxyde de silicium préparé par pyrogénation, dopé à l'oxyde de cérium.

9. Procédé pour la préparation d'une dispersion aqueuse selon la revendication 8, **caractérisé en ce que** pour le broyage et la dispersion d'un dioxyde de silicium dopé à l'oxyde de cérium dans un solvant aqueux, on utilise un dispositif dans lequel les particules à disperser sont soumises à une pression allant jusqu'à 3 500 kg/cm², sont détendues dans une buse et entrent en collision les unes avec les autres ou contre des zones de paroi du dispositif.

10. Utilisation de la dispersion aqueuse selon l'une quelconque des revendications 1 à 7, pour le polissage chimique-mécanique de substrats de semiconducteurs ou de couches appliquées sur ceux-ci.

11. Utilisation de la dispersion aqueuse selon l'une quelconque des revendications 1 à 7, pour la production de revêtements superficiels finement divisés dans le domaine du papier.

12. Utilisation de la dispersion aqueuse selon l'une quelconque des revendications 1 à 7, pour la fabrication de verres spéciaux.
